# FASCICULE DE BREVET EUROPEEN

(11) **EP 0 939 372 B1**
(45) Date de publication et mention de la délivrance du brevet: **15.01.2003**
(21) Numéro de dépôt: 99400461.2
(22) Date de dépôt: 25.02.1999
(51) Int. Cl.: G06F 11/24

(54) **Dispositif de test en production des caractéristiques dynamiques de composants utilisant des transmissions série**
Gerät zur Produktionskontrolle der dynamischen Eigenschaften von Komponenten mit serieller Übertragung
Device for production testing of the dynamic characteristics of components using serial transmission

(30) Priorité: 27.02.1998 FR 9802401
(43) Date de publication de la demande: 01.09.1999
(73) Titulaire: STMicroelectronics S.A., 92120 Montrouge (FR)
(72) Inventeur: Couteaux, Pascal, 75116 Paris (FR); Marbot, Roland, 75116 Paris (FR); Nezamzadeh, Reza, 7516 Paris (FR)
(74) Mandataire: Ballot, Paul

(56) Documents cités:
- WO-A-97/02493
- US-A- 5 481 563
- US-A- 5 640 401

## Description

L'invention concerne un dispositif de test en production des caractéristiques dynamiques de composants ou de circuits utilisant des transmissions séries. L'invention se rapporte tout particulièrement au domaine de l'évaluation de la résistance des composants ou de circuits utilisant des transmissions série, face aux phénomènes de dispersion de fréquences et aux fluctuations de fréquence.

Les phénomènes de dispersion de fréquence correspondent à un décalage en fréquence observé entre différents quartz de même fréquence nominale. Les origines de ce décalage sont le plus souvent inhérentes aux composants même du circuit considéré. Les fluctuations de fréquence ont le plus souvent des origines externes aux circuits considérés. Mais elles peuvent également provenir des composants utilisés. Ces fluctuations de fréquence se traduisent par de faibles variations aléatoires de fréquence entre le signal reçu et le signal émis. Ce phénomène se nomme le "jitter" dans la littérature anglaise.

Il existe deux grands types de transmissions câblées entre un émetteur et un récepteur. On parle tout d'abord de transmission parallèle. Une transmission dite parallèle se caractérise par l'envoi d'informations sous forme de signaux binaires et d'un signal d'horloge ; les informations sont envoyées sur différentes liaisons entre l'émetteur et le récepteur. A la réception des signaux, les informations sont échantillonnées par le signal d'horloge. Il existe une limitation fréquentielle importante pour ce type de transmission du fait de la non simultanéité de l'arrivée des informations dans le récepteur. En effet, il faut attendre que la totalité des informations constituant un premier groupe de données transmis soit parvenue au récepteur avant de valider, par le signal d'horloge, l'envoi du groupe de données suivant. Cette différence des temps de transit sur la ligne de transmission parallèle entre les différents signaux de données et l'horloge est inhérente à ce type de communication entre l'émetteur et le récepteur. On parle dans la littérature anglaise de "skew".

L'autre mode de transmission câblée est un mode de transmission série. Par opposition au mode de transmission parallèle, une transmission série se caractérise par l'envoi des informations, contenant les données à transmettre et le signal d'horloge, sur un seul signal. Ce signal doit donc véhiculer simultanément les informations de données et l'information d'horloge. A la réception du signal, on doit extraire le signal d'horloge du train de bit reçu. Ce signal d'horloge sert alors pour échantillonner les données contenues dans ce même train de bit.

De ce fait, la limitation en fréquence imposée par les transmissions parallèles (le "skew") est éliminée. On peut ainsi transmettre les données sur un seul fil à des débits beaucoup plus élevés. Par conséquent, le coût incompressible de la liaison, qui peut être soit un câble en cuivre soit une fibre optique, est mieux rentabilisé. Cependant, une liaison série connaît également une limitation fréquentielle provenant essentiellement de deux phénomènes. Tout d'abord, toute liaison impose, du fait de sa bande passante, une limitation en fréquence des signaux qu'elle véhicule. Au delà de certaines fréquences, l'atténuation des signaux dans les câbles est trop importante pour exploiter les informations transmises au niveau des récepteurs. D'autre part, chaque élément intervenant dans la liaison introduit et est sujet à des perturbations de fréquence. Ce phénomène peut venir de l'émetteur lui-même, des supports de la liaison, que ce soit un câble en cuivre ou une fibre optique, ou encore du bruit électrique. Cependant, quand une liaison parallèle peut fonctionner à 100 MHz, une liaison série peut typiquement fonctionner à plusieurs mégabits par seconde.

La clé pour mettre en oeuvre des liaisons séries économiquement viables, est de savoir faire intervenir dans des composants à faibles coûts des composants dits dispositifs de multiplexage et d'autres composants dits dispositifs de démultiplexage. Les dispositifs de multiplexage permettent de faire passer les données à transmettre sur un seul fil. Les dispositifs de démultiplexage permettent de récupérer l'horloge dans le signal série et de démultiplexer les données reçues. De tels composants (par exemple ceux développés par SGS THOMSON sous les références FC106, GE105, SBPH400-3, etc...) posent souvent un grand nombre de problèmes, notamment au niveau des tests lors de leur mise en production. En effet, il n'existe pas sur le marché de testeur de circuit intégré permettant de sonder ou de générer des signaux dans la gamme de vitesse de transmission de l'ordre des gigabits (10⁹ bits) par seconde.

Cette contrainte implique que le composant doit être muni d'un dispositif d'auto-test. Ce dispositif doit comprendre un oscillateur interne activant le circuit dans sa gamme de fonctionnement et un générateur de données, le plus souvent pseudo-aléatoire. Ces données sont envoyées sous la forme de signaux binaires au dispositif de multiplexage qui les transforme en un signal série. Le composant doit, en mode auto-test, envoyer ce signal série sur l'entrée du dispositif de démultiplexage qui va récupérer l'horloge et démultiplexer les signaux binaires. Ensuite, ces signaux binaires récupérés sont envoyés vers un circuit logique qui vérifie leur conformité, détecte les éventuelles erreurs et les dénombre. Ainsi, en initialisant le circuit en mode auto-test, et en le laissant tourner en autonome pendant quelques millisecondes, puis en allant relire le compteur d'erreurs, on peut tester le fonctionnement du composant sur un quelconque testeur basse fréquence. Ce type de pratique peut s'appliquer tant au niveau d'un circuit intégré qu'au niveau des composants assemblés ou boîtiers.

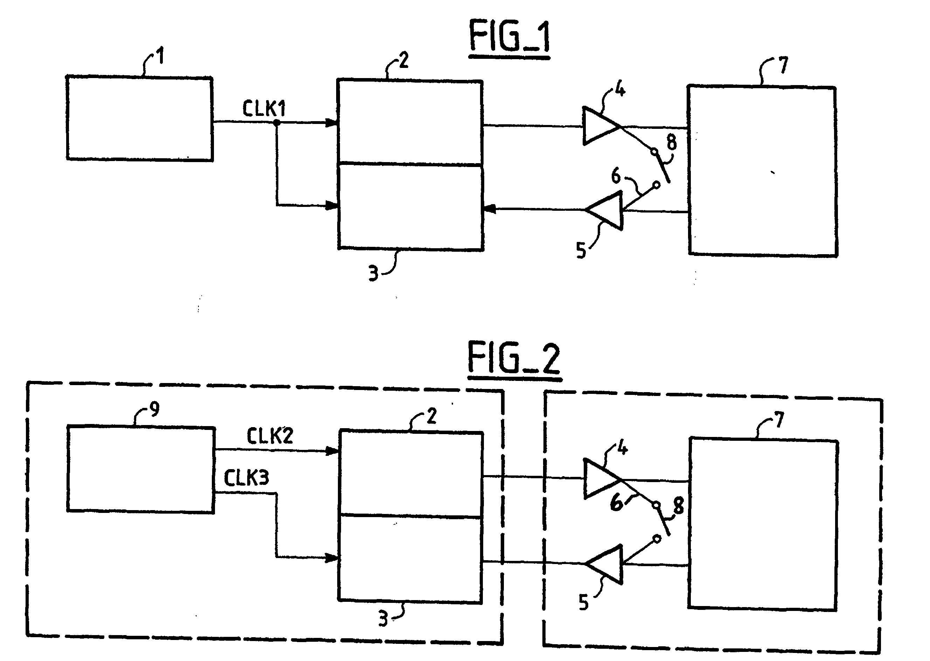

La figure 1 représente le schéma de principe d'un tel dispositif d'auto-test. Un dispositif 1, fournissant l'horloge, émet un signal d'horloge CLK1. Ce signal d'horloge CLK1 est reçu à la fois par un émetteur 2 et par un récepteur 3. La sortie de l'émetteur 2 est reliée à un dispositif de multiplexage 4. Un dispositif de démultiplexage 5 est connecté à une entrée du récepteur 3. Le dispositif de multiplexage 4 délivre un signal qui est envoyé en entrée d'un circuit de traitement de données 7. Ce circuit de traitement de données 7 émet un signal qui est reçu par le dispositif de démultiplexage 5. Une liaison 6 reboucle directement la sortie du dispositif de multiplexage 4 sur l'entrée du dispositif de démultiplexage 5. Le récepteur 3 est de préférence un circuit logique vérifiant l'intégrité des signaux reçus. Cette liaison 6 est contrôlée par un interrupteur 8. En fonctionnement normal, la liaison 6 est ouverte et par conséquent n'intervient pas. Cette liaison 6 intervient dans le cadre de l'auto-test.

Cette technique d'auto-test est très efficace. Elle ne permet cependant pas de tester toutes les caractéristiques dynamiques du composant car elle ne correspond pas aux conditions réelles d'exploitation de ce composant. En effet, dans une application réelle, les composants communiquant entre eux au travers de la liaison série sont activés par des horloges dont les signaux sont générés par des oscillateurs à quartz de même fréquence nominale. Cependant, ces oscillateurs à quartz présentent inévitablement des dispersions de fréquence (typiquement 100 ppm). Le composant doit compenser ces dispersions de fréquence. Or le générateur d'auto-test active l'émetteur et le récepteur avec le signal d'horloge générée par le seul oscillateur interne. On se retrouve donc dans le cas idéal où les dispersions de fréquence sont absentes. Ce cas idéal est éloigné de la réalité.

D'autre part, les conditions d'exploitation réelles ne sont pas respectées, car la liaison entre l'émetteur et le récepteur est interne au composant. Elle est donc très peu perturbée. Cette technique ne permet donc pas de mesurer la robustesse de la liaison face à des sources de fluctuations de fréquence externes.

Cette technique d'auto-test est connue pour les tests de composants intégrant des liaisons séries. Aujourd'hui ces limitations sont approximativement contournées en échantillonnant des composants, en les montant sur carte et en procédant à des tests plus approfondis sur ces échantillons. Mais ces tests représentent un coût non négligeable dans la production et ne couvrent pas tous les composants.

L'invention a donc pour objet de proposer une solution exhaustive à ces problèmes. Elle propose un système permettant de tester la robustesse de chaque composant, face aux dispersions de fréquence et aux fluctuations de fréquence en mode auto-test. Elle permet donc une caractérisation exhaustive de performances dynamiques des composants à un coût compatible avec les contraintes de production de masse. Les contraintes principales sont les suivantes : on a, aujourd'hui encore, du mal à générer un signal d'horloge externe capable d'avoir un débit de l'ordre du gigahertz. D'autre part, même si on parvenait à réaliser une telle horloge, il faudrait pouvoir, à partir de cette unique horloge générer deux signaux d'horloge de périodes légèrement différentes, pour pouvoir observer la dérive entre les fronts du signal d'horloge fourni à l'émetteur du circuit par rapport aux fronts du signal d'horloge fourni au récepteur du circuit.

La solution au problème consiste à générer dans le composant, et plus précisément dans le bloc d'auto-test, deux signaux d'horloge au lieu d'un : un premier signal d'horloge est destiné au dispositif de multiplexage, un second signal d'horloge est destiné au dispositif de démultiplexage. Ces deux horloges ont des fréquences très sensiblement différentes. Cette différence de fréquences peut être constante et modéliser ainsi la dispersion de fréquences des oscillateurs à quartz. La différence de fréquences peut être également variable et modéliser ainsi un effet de fluctuations de fréquence sur la ligne. En effet, les variations pseudo-aléatoires de fréquence de l'horloge de l'émetteur induisent des variations similaires sur le signal série généré identiques à des fluctuations incontrôlées de fréquence. En contrôlant cette différence de fréquences, on peut mesurer la résistance du composant aux dispersions de fréquences et aux fluctuations de fréquence; il suffit pour cela d'augmenter progressivement la différence de fréquences, et relever le seuil à partir duquel le circuit d'auto-test détecte des erreurs de transmission.

L'invention telle que définie par la revendication 1 a donc pour objet un dispositif de test des caractéristiques dynamiques de composant électronique ou de circuit électronique utilisant des transmissions série ledit composant ou circuit comprenant un dispositif de multiplexage et un dispositif de démultiplexage pour mettre en oeuvre une liaison série dans le composant ou le circuit, ledit dispositif de test comprenant un émetteur fournissant au dispositif de multiplexage les données à multiplexer, un récepteur recevant les données démultiplexées en sortie du dispositif de démultiplexage, une liaison assurant au moyen d'un interrupteur de contrôle la connection directe entre la sortie du dispositif de multiplexage et l'entrée du dispositif de démultiplexage, et caractérisé en ce qu'il comprend un dispositif délivrant un premier signal d'horloge et un second signal d'horloge, le premier signal d'horloge étant appliqué en entrée de l'émetteur, le second signal d'horloge étant appliqué en entrée du récepteur, le premier signal d'horloge et le second signal d'horloge ayant des fréquences très sensiblement différentes.

Les différents aspects et avantages de l'invention apparaîtront dans la suite de la description en référence aux figures qui ne sont données qu'à titre indicatif et nullement limitatif de l'invention. Les figures montrent :
- la figure 1, déjà décrite représente le schéma de principe d'un dispositif d'auto-test;
- la figure 2 montre un schéma de principe d'un dispositif d'auto-test selon l'invention;
- la figure 3 montre deux chronogrammes représentant les deux signaux d'horloge qui seront utilisés dans l'invention;
- la figure 4 montre le schéma de principe d'un circuit à retard variable utilisé dans le cadre de l'invention pour générer le second signal d'horloge à partir du premier signal d'horloge;
- la figure 5 montre une représentation détaillée d'un dispositif d'auto-test selon l'invention.

Le schéma de principe du système d'auto-test selon l'invention est représenté sur la figure 2. Comme sur la figure 1, on trouve un dispositif 9 qui diffère du dispositif 1 de la figure 1. En effet, ce dispositif 9 délivre deux signaux d'horloge CLK2 et CLK3. Le premier signal d'horloge CLK2 est reçu par l'émetteur 2, le second signal d'horloge CLK3 est reçu par le récepteur 3. L'émetteur 2 est souvent un générateur de données pseudo-aléatoires, et le récepteur 3 est souvent un circuit logique qui vérifie l'intégrité des données reçues. Le récepteur 3 est relié à un compteur d'erreurs vérifiant l'intégrité des signaux reçus. La sortie de l'émetteur 2 est reliée à un premier circuit 4, qui est de préférence un dispositif de multiplexage. Ce premier circuit 4 délivre un signal qui est envoyé en entrée d'un circuit de traitement de données 7. Ce circuit de traitement de données 7 émet un signal qui est reçu par l'entrée d'un second circuit 5. Ce second circuit 5 est de préférence un dispositif de démultiplexage dont la sortie est connectée à l'entrée du récepteur 3.

Conformément à ce qui avait été décrit lors de la présentation de la figure 1, la sortie du dispositif de multiplexage 4 et l'entrée du dispositif de démultiplexage 5 sont directement reliés à l'aide d'une connexion 6. Ce court-circuit est commandé par un interrupteur 8. Le dispositif 9 fournissant le premier signal d'horloge CLK2 et le deuxième signal d'horloge CLK3, associé à l'émetteur 2, au récepteur 3 et à la liaison 6, permettant de court-circuiter le circuit de traitement de données 7, constituent un dispositif de test. Le dispositif de multiplexage 4, le dispositif de démultiplexage 5 et le circuit de traitement de données 7 constituent un composant ou un circuit à tester.

Quand l'interrupteur 8 est fermé, le fait de disposer d'un second signal d'horloge CLK3 différent du premier signal d'horloge CLK2 en éntrée du récepteur 3, permet d'effectuer un auto-test correspondant aux conditions réelles d'utilisation. Le récepteur 3 peut en effet alors comparer les signaux binaires issus du dispositif de démultiplexage 5 avec ceux qui sont directement transmis par l'émetteur 2, et ceci en tenant compte d'un signal d'horloge différent de celui présent dans l'émetteur. On peut ainsi observer les dysfonctionnements survenus dans le circuit ou composant à tester dans des conditions réelles d'exploitation.

Ainsi, l'émetteur 2 et le récepteur 3 reçoivent désormais deux signaux d'horloge distincts CLK2 et CLK3. On va donc pouvoir, en contrôlant ces deux signaux d'horloge simuler les effets de dispersion de fréquences et de fluctuation de fréquences sur le composant testé dans des conditions plus proche de la réalité.

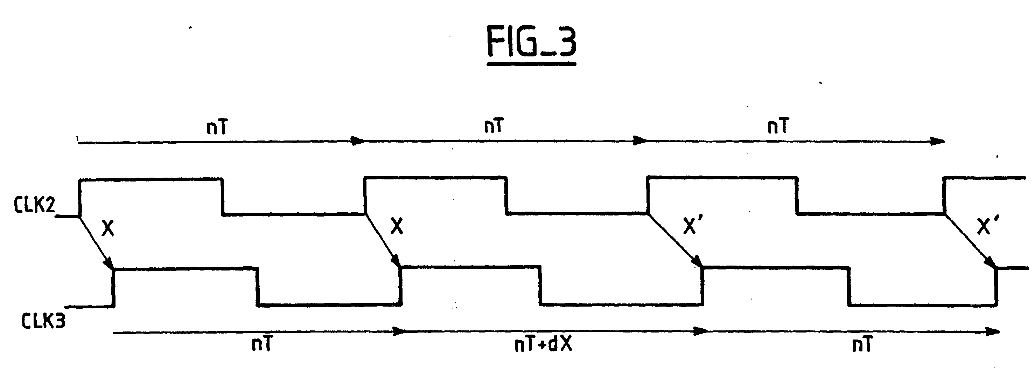

La figure 3 représente deux chronogrammes correspondant aux allures éventuelles des deux signaux d'horloge CLK2 et CLK3. Si le premier signal d'horloge CLK2 représente la première horloge, le second signal d'horloge CLK3 est obtenu en retardant le premier signal d'horloge CLK2 par un retard variable X. Lorsque X est maintenu constant pour deux périodes consécutives du premier signal d'horloge CLK2, la période du second signal d'horloge CLK3 est égale à celle du premier signal d'horloge CLK2. En changeant X pour la valeur X' = X + dX, la période correspondante du second signal d'horloge CLK3 est changée d'une valeur dX par rapport à la période correspondante du premier signal d'horloge CLK2. La valeur dX peut être positive ou négative. En conséquence, la période moyenne du deuxième signal d'horloge CLK3, et donc la fréquence du deuxième signal d'horloge CLK3 a changé par rapport à la période du premier signal d'horloge CLK2, donc par rapport à la fréquence du premier signal d'horloge CLK2. Ainsi, en contrôlant l'écart dX et la fréquence de changement du retard X, on contrôle la variation de fréquence entre les signaux CLK2 et CLK3.

A titre d'exemple, supposons que la période nT du premier signal d'horloge CLK2 est de dix nanosecondes (ce qui correspond à une fréquence de 100 MHz) et que l'écart dX vaut 20 picosecondes. Dans ce cas, si on change la commande du retard X, à chaque période du signal CLK2, le signal CLK3 sera formé de périodes identiques de valeur 10,02 nanosecondes. Ceci correspond à une variation de fréquence entre les signaux CLK2 et CLK3 de deux pour-cent. Avec les mêmes hypothèses, si on change la commande du retard X toutes les dix périodes du signal CLK2, le signal CLK3 sera composé de neuf périodes de dix nanosecondes et d'une période de 10,02 nanosecondes, soit une période moyenne de 10,002 nanosecondes. Ceci correspond à une variation de fréquences entre les signaux CLK2 et CLK3 de deux pour dix mille.

De façon analogue, si le retard X est augmenté de X à X' sur les périodes dites impaires (c'est-à-dire la première, troisième, ... période) du signal CLK2, et diminué de X' à X sur les périodes dites paires (c'est-à-dire la deuxième, quatrième, ... période) du signal CLK2, alors le signal CLK3 sera composé de périodes dites impaires de valeur 10,02 nanosecondes et de périodes dites paires de valeur 9,98 nanosecondes. On a ainsi une période moyenne de dix nanosecondes et une fluctuation ("jitter" dans la littérature anglaise) de 40 picosecondes. Ainsi, en faisant varier les retards X, soit par la différence entre X et X', soit par la fréquence de ces changements, on change l'amplitude des fluctuations mesurées en picosecondes dans l'exemple décrit, et la fréquence de modulation de ces fluctuations. On peut ainsi mesurer la robustesse des composants pour des fluctuations de fréquence différentes de différentes natures.

Générer deux signaux d'horloge à des fréquences très peu différentes ne peut pas se faire à partir de deux oscillateurs différents. En effet, les dispersions entre transistors d'un même circuit intégré sont de quelques pour-cent. Ceci est trop important dans le cadre de l'invention. La solution adoptée est de générer le deuxième signal d'horloge en retardant le premier signal d'horloge. Pour ceci, on utilise un circuit à retard variable.

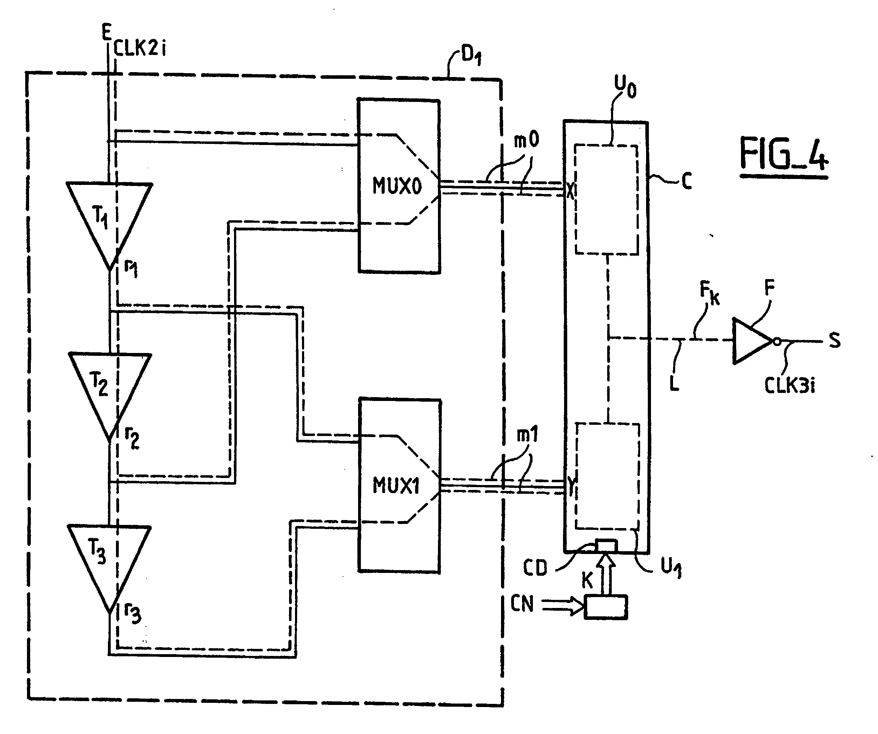

La figure 4 représente un tel circuit à retard variable. Il sera désigné par la suite comme circuit à retard variable élémentaire. Ce circuit comporte un circuit primaire D1 à retard fixe. Le circuit à retard fixe D1 reçoit un premier signal d'horloge intermédiaire CLK2i et fournit en sortie des premier et deuxième signaux intermédiaire m0 et m1.

Les signaux m0 et m1 présentent entre eux un retard fixe T. Les signaux m0 et m1 sont appliqués respectivement aux entrées X et Y d'un circuit de combinaison C fournissant en sortie un signal de combinaison f_{K}. Le circuit de combinaison C comporte une entrée de commande CD recevant une commande K représentative des coefficients de pondération de la combinaison effectuée par le circuit C. Cette commande K est fonction d'une consigne de retard CN.

Le signal de combinaison f_{K} est appliqué à l'entrée d'un circuit de mise en forme F dont la sortie S fournit un second signal d'horloge intermédiaire CLK3i. Pour simplifier la suite de l'exposé, on raisonnera sur les grandeurs normalisées des signaux impliqués et on supposera que les coefficients de pondération affectés aux signaux m0 et m1 sont respectivement les valeurs K et 1 - K, avec K compris entre 0 et 1.

Dans ces conditions, le circuit C est conçu pour réaliser la combinaison g_{K} = K.m0 + (1 - K).m1 avec intégration par rapport au temps pour obtenir le signal de combinaison fₖ à partir de la combinaison gₖ.

Le signal CLK2i arrive à l'entrée E du circuit sur une première mémoire tampon T1 ("buffer" dans la littérature anglaise). Dans l'exemple préféré représenté, trois mémoires tampons identiques T1, T2 et T3 sont montées en série. Elles servent à introduire en série des retards fixes au signal CLK2i. De préférence, les retards fixes sont tous égaux entre eux à T de sorte que le signal CLK2i soit retardé de T, 2T, 3T, etc... Mais les retards pourraient être différents les uns des autres. Le signal r1 est à la sortie de la mémoire tampon T1, le signal r2 est à la sortie de la mémoire tampon T2, le signal r3 est à la sortie de la mémoire tampon T3. L'entrée de la première mémoire tampon est connectée à l'une des deux entrées d'un premier multiplexeur MUX0. La sortie de la mémoire tampon T2 constitue l'autre entrée du multiplexeur MUX0. Les sorties des mémoires tampons T1 et T3 sont connectées aux deux entrées d'un second multiplexeur MUX1. Les sorties des multiplexeurs MUX0 et MUX1 sont connectées aux entrées du circuit de combinaison C réalisant une interpolation de retard. La sortie du circuit de combinaison conduit le signal f_{K} au circuit de mise en forme F. Le circuit de combinaison est constitué de deux modules U0 et U1. L'interpolation peut ainsi être réalisée entre soit les signaux CLK2i et r1, soit les signaux r2 et r1, soit les signaux r2 et r3. Ces trois combinaisons sont les seules à présenter un retard constant égal à T entre les signaux. En présentant les signaux de ces trois combinaisons de signaux à l'entrée du circuit de combinaison, on est certain d'obtenir une plage de retard constante. L'objectif de ce type de circuit est d'obtenir une linéarité optimale entre la commande numérique CN et le retard du signal CLK3i sur le signal CLK2i. La combinaison des signaux CLK2i et r3 ne sera jamais appliquée à l'entrée du circuit de combinaison, car le retard entre les deux signaux serait trop important et ne satisferait pas aux conditions de linéarité.

Plusieurs plages de retard peuvent ainsi être mises à la suite. La mise à la suite de ces plages de retard consiste à utiliser une première combinaison CLK2i et r1 pour produire un retard variable entre 0 et T, à utiliser une deuxième combinaison r1 et r2 pour produire un retard variable entre T et 2T, à utiliser une troisième combinaison r2 et r3 pour produire un retard variable entre 2T et 3T et ainsi de suite, le nombre de mémoires tampons utilisées et la capacité des multiplexeurs conditionnant la dynamique totale de retard des circuits de retard.

De tels circuits sont connus dans l'art antérieur, ils ne seront par conséquent pas détaillés plus précisément par la suite. Cependant, on utilisera de préférence les circuits du type décrit dans le brevet français publié sous le numéro 2 690 022 intitulé "Circuit à retard variable" qui concerne un circuit à retard variable présentant une linéarité optimale du retard entre le signal de sortie de ce circuit, et le signal d'entrée de ce circuit en fonction de la consigne de retard.

Dans une autre application préférée, on pourra utiliser le circuit à retard variable décrit dans le brevet français publié sous le numéro 2 689 339 intitulé "procédé et dispositif de réglage de retard à plusieurs gammes".

Dans tous les cas, ces circuits couvrent, en assurant une réponse parfaitement linéaire du retard entre un signal d'entrée et un signal de sortie en fonction d'une consigne numérique, une plage de retard de 1,5 nanoseconde.

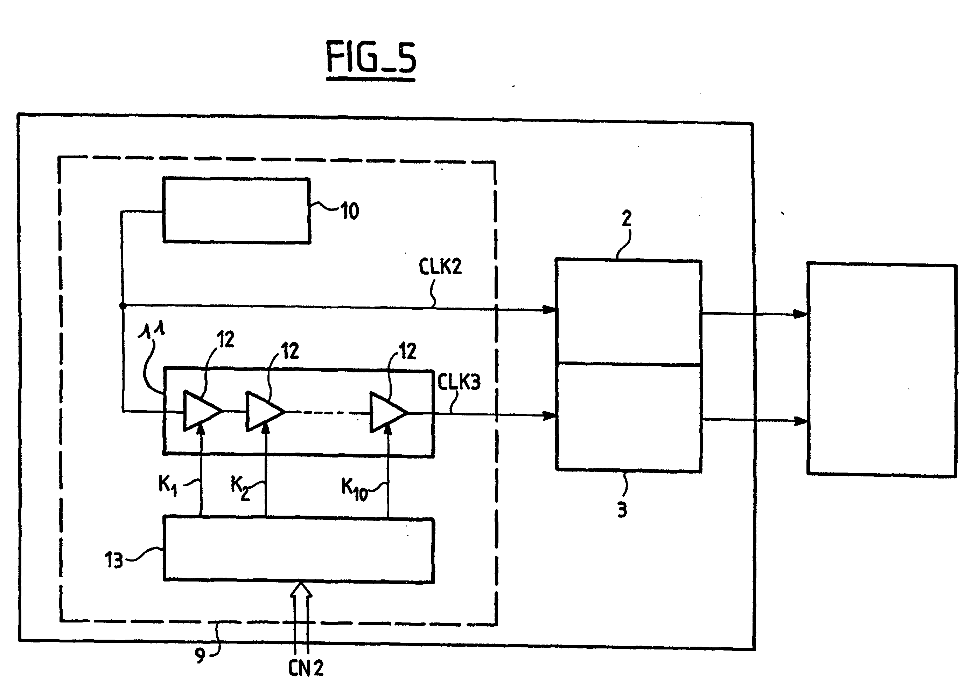

Ce type de circuit à retard variable élémentaire apparait sur la figure 5. La figure 5 montre une représentation détaillée d'un dispositif d'auto test pour l'invention. Sur cette figure on retrouve le dispositif 9 qui délivre les signaux d'horloge CLK2 et CLK3. Ce dispositif 9 se compose d'un oscillateur 10 qui délivre le premier signal d'horloge CLK2. Ce premier signal d'horloge CLK2 est fourni en sortie du dispositif 9 à l'entrée de l'émetteur 2. Le premier signal d'horloge CLK2 arrive également à l'entrée d'un circuit à retard variable 11. Ce circuit à retard variable 11 est en fait constitué de dix circuits à retard variable élémentaires 12 connectés en série. Ces circuits à retard variable élémentaires 12 sont tels que ceux décrits lors de la description de la figure 4. Un circuit de commande 13 permet, à partir d'une consigne numérique CN2, de générer des grandeurs de commande K1, K2 ... K10 contrôlant les retards des circuits à retard variable élémentaires.

Au début des tests, les commandes des dix circuits à retard variable élémentaires de cette chaîne sont mis à la plus petite valeur. On a alors un retard en sortie du circuit à retard variable 11 de l'ordre de 5 nanosecondes. Ainsi, le second signal d'horloge CLK3, fourni en sortie du circuit à retard variable 11, est déphasé de 5 nanosecondes par rapport au premier signal d'horloge CLK2. Au fur et à mesure des tests, on augmente progressivement la valeur de la commande K1 du premier circuit à retard variable élémentaire 12. Puis, on augmente petit à petit les grandeurs de commande des autres circuits à retard variable élémentaire 12. On balaie ainsi progressivement une plage de temps de propagation entre un temps de propagation minimum et un temps de propagation maximum. Le temps de propagation maximum est d'environ 15 nanosecondes.

On comprend ainsi l'intérêt d'avoir disposé en série dix circuits à retard variable élémentaires 12. En effet, chacun de ces circuits à retard variable 12 n'admettait une réponse linéaire du retard en fonction de la commande numérique que sur une durée de 1,5 nanosecondes. En disposant en série une dizaine de circuits à retard variable élémentaires 12, on est sûr, en travaillant autour d'une fréquence de 100 MHz, de pouvoir disposer d'un temps de propagation supérieur à la période du premier signal d'horloge CLK2. Ainsi, l'étude de la dérive que peuvent présenter deux oscillateurs différents sur les fronts montants de leurs signaux sera optimale. Comme décrit précédemment sur la figure 2, le second signal d'horloge CLK3 issu du dispositif 9 est fourni en entrée du récepteur 3.

L'oscillateur 10 utilisé est dans une application préférée un oscillateur en anneau constitué de cinq circuits de retard variable élémentaires tels que ceux décrits sur la figure 4. Il peut donc également être contrôlé par une commande numérique qui permet d'obtenir une grande précision dans la détermination de la période du premier signal d'horloge CLK2.

## Revendications

1. Dispositif de test des caractéristiques dynamiques de composant électronique ou de circuit électronique utilisant des transmissions série ledit composant ou circuit comprenant un dispositif de multiplexage (4) et un dispositif de démultiplexage (5) pour mettre en oeuvre une liaison série dans le composant ou le circuit, ledit dispositif de test comprenant un émetteur (2) fournissant au dispositif de multiplexage (4) des signaux binaires à multiplexer, un récepteur (3) recevant les signaux binaires démultiplexés en sortie du dispositif de démultiplexage (5), une liaison (6) assurant au moyen d'un interrupteur de contrôle (8) la connexion directe entre la sortie du dispositif de multiplexage 4 et l'entrée du dispositif de démultiplexage 5, et **caractérisé en ce qu'**il comprend un dispositif (9) délivrant un premier signal d'horloge (CLK2) et un second signal d'horloge (CLK3), le premier signal d'horloge (CLK2) étant appliqué en entrée de l'émetteur (2), le second signal d'horloge (CLK3) étant appliqué en entrée du récepteur, le premier signal d'horloge (CLK2) et le second signal d'horloge (CLK3) ayant des fréquences différentes.

2. Dispositif de test selon la revendication 1, **caractérisé en ce que** le premier signal d'horloge (CLK2) et le deuxième signal d'horloge (CLK3) sont délivrés par un dispositif (1) comprenant un unique oscillateur à fréquence programmable (10) et par un circuit à retard variable (13), l'oscillateur à fréquence programmable (10) délivrant le premier signal d'horloge (CLK2), le circuit à retard variable (13) délivrant le second signal d'horloge (CLK3) en retardant le premier signal d'horloge (CLK2).

3. Dispositif de test selon la revendication 2, **caractérisé en ce que** le circuit à retard variable (13) est réglable de façon linéaire en fonction d'une consigne numérique (CN2), le retard entre le premier signal d'horloge (CLK2) et le second signal d'horloge (CLK3) pouvant atteindre au moins la valeur d'une période du premier signal d'horloge (CLK2).

4. Dispositif de test selon l'une quelconque des revendications précédentes **caractérisé en ce que** le premier signal d'horloge (CLK2) et le second signal d'horloge (CLK3) ont des fréquences de l'ordre de 100 MHz.

5. Dispositif de test selon l'une quelconque des revendications précédentes **caractérisé en ce qu'**il fournit une différence de fréquence entre le premier signal d'horloge (CLK2) et le second signal d'horloge (CLK3) de l'ordre de 2 pour 10 000.

6. Dispositif de test selon l'une quelconque des revendications précédentes, **caractérisé en ce que** le circuit à retard variable (13) comprend une succession de circuits à retard variables élémentaires (12) disposés en série, chaque circuit à retard variable élémentaire (12) fournissant en sortie un second signal d'horloge intermédiaire (CLK3i) présentant un retard (X) par rapport à un premier signal d'horloge intermédiaire (CLK2i), le retard (X) étant réglable en fonction d'une consigne de retard (CN), le circuit à retard variable élémentaire (12) comprenant
- un circuit primaire (D1) comprenant un jeu de mémoires tampons (T1, T2, T3) en série, retardant pour chacune le signal à sa sortie d'un retard (T), à la sortie desquelles on obtient au moins des premier et deuxième signaux retardés (r1, r2), le premier signal d'horloge intermédiaire (CLK2i) et les signaux retardés (r1, r2) étant appliqués aux entrées d'un premier et d'un deuxième multiplexeur (MUX0, MUX1) qui fournissent des premier et deuxième signaux intermédiaires (m0, m1),
- un circuit de combinaison (C) à deux entrées (X, Y), comprenant une entrée de commande (CD) recevant une grandeur de commande (K) représentative de la consigne de retard (CN), une ligne commune (L), un premier et un second module de charge et décharge (U0, U1) de la ligne commune (L) commandés respectivement par les premier et second signaux intermédiaires (m0, m1), le potentiel de la ligne commune (L) constituant la mesure du signal de combinaison (f_{K}), les signaux intermédiaires (m0, m1) étant appliqués aux entrées (X, Y), fournissant en sortie un signal de combinaison (f_{K}) résultant d'une superposition avec une pondération fonction de la grandeur de commande (K) et un effet d'intégration des signaux appliqués sur ses entrées (X, Y) ,
- un circuit de mise en forme (F) recevant le signal de combinaison, fournissant le second signal d'horloge intermédiaire (CLK3i), et présentant un effet de seuil.

7. Dispositif de test selon l'une quelconque des revendications précédentes, **caractérisé en ce que** l'émetteur (2) est un générateur de données pseudo-aléatoires.

8. Dispositif de test selon l'une quelconque des revendications précédentes, **caractérisé en ce que** le récepteur (3) est un circuit logique permettant de vérifier l'intégrité des signaux binaires en sortie du dispositif de démultiplexage (5) dans des conditions réelles d'utilisation.

## Patentansprüche

1. Vorrichtung zum Überprüfen von dynamischen Eigenschaften eines elektronischen Bauteils oder einer elektronischen Schaltung, die serielle Übertragungen verwendet, wobei das Bauteil oder die Schaltung einen Multiplexer (4) und einen Demultiplexer (5) umfaßt, um eine serielle Verbindung in dem Bauteil oder der Schaltung herzustellen, wobei die Überprüfungsvorrichtung einen Emitter (2), der dem Multiplexer (4) binäre Multiplexersignale übermittelt, einen Empfänger (3), der die von dem Demultiplexer (5) ausgegebenen binären, demultiplexierten Signale empfängt, eine Verbindung (6), die mittels eines Kontrollschalters (8) die direkte Verbindung zwischen dem Ausgang des Multiplexers (4) und dem Eingang des Demultiplexers (5) sicherstellt, umfaßt, **gekennzeichnet durch** eine Vorrichtung (9), die ein erstes Taktsignal (CLK2) und ein zweites Taktsignal (CLK3) übermittelt, wobei das erste Taktsignal (CLK2) an dem Eingang des Emitters (2) angelegt wird, das zweite Taktsignal (CLK3) an dem Eingang des Empfängers angelegt wird und das erste Taktsignal (CLK2) sowie das zweite Taktsignal (CLK3) unterschiedliche Frequenzen aufweisen.

2. Vorrichtung nach Anspruch 1, **dadurch gekennzeichnet, daß** das erste Taktsignal (CLK2) und das zweite Taktsignal (CLK3) durch eine Vorrichtung (1), die einen einzigen Oszillator (10) mit einer programmierbaren Frequenz umfaßt, und durch eine Schaltung (13) mit einer variablen Verzögerung übermittelt werden, wobei der Oszillator (10) mit programmierbarer Frequenz das erste Taktsignal (CLK2) übermittelt und die Schaltung (13) mit variabler Verzögerung ein zweites Taktsignal (CLK3) mit einer Verzögerung des ersten Taktsignals (CLK2) übermittelt.

3. Vorrichtung nach Anspruch 2, **dadurch gekennzeichnet, daß** die Schaltung (13) mit variabler Verzögerung als Funktion eines numerischen Einstellwertes (CN2) linear regelbar ist, wobei die Verzögerung zwischen dem ersten Taktsignal (CLK2) und dem zweiten Taktsignal (CLK3) zumindest den Wert einer Periode des ersten Taktsignals (CLK2) erreichen kann.

4. Vorrichtung nach einem der vorangegangenen Ansprüche, **dadurch gekennzeichnet, daß** das erste Taktsignal (CLK2) und das zweite Taktsignal (CLK3) Frequenzen in der Größenordnung von 100 MHz aufweisen.

5. Vorrichtung nach einem der vorangegangenen Ansprüche, **dadurch gekennzeichnet, daß** sie einen Frequenzunterschied zwischen dem ersten Taktsignal (CLK2) und dem zweiten Taktsignal (CLK3) in der Größenordnung von 2 bei 10.000 bereitstellt.

6. Vorrichtung nach einem der vorangegangenen Ansprüche, **dadurch gekennzeichnet, daß** die Schaltung (13) mit variabler Verzögerung eine Folge von elementaren Schaltungen (12) mit variabler Verzögerung umfaßt, die in Reihe geschaltet sind, wobei jede elementare Schaltung (12) mit variabler Verzögerung am Ausgang ein zweites Zwischentaktsignal (CLK3i) liefert, das eine Verzögerung (X) bezüglich eines ersten Zwischentaktsignals (CLK2i) aufweist, wobei die Verzögerung (X) als Funktion eines Verzögerungseinstellwerts (CN) regelbar ist, wobei die elementare Schaltung (12) mit variabler Verzögerung umfaßt:
- eine primäre Schaltung (D1), die einen Satz Pufferspeicher (T1, T2, T3) in Serie umfaßt, die jeweils das Signal an ihrem Ausgang mit einer Verzögerung (T) verzögern, an deren Ausgang zumindest ein erstes und ein zweites verzögertes Signal (r1, r2) erhalten wird, wobei das erste Zwischentaktsignal (CLK2i) und die verzögerten Signale (r1, r2) an den Eingängen eines ersten und eines zweiten Multiplexers (MUX0, MUX1) angelegt werden, die das erste und das zweite Zwischensignal (m0, m1) liefern,
- eine Kombinationsschaltung (C) mit zwei Eingängen (X, Y), die einen Steuereingang (CD), der eine Steuergröße (K) empfängt, die dem Verzögerungseinstellwert (CN) entspricht, eine gemeinsame Leitung (L), ein erstes und ein zweites Modul (U0, U1) zum Belasten und Entlasten der gemeinsamen Leitung (L) umfaßt, wobei die Module jeweils durch das erste und zweite Zwischensignal (m0, m1) gesteuert sind, wobei das Potential der gemeinsamen Leitung (L) die Messung des Kombinationssignals (f_{K}) darstellt, wobei die Zwischensignale (m0, m1) an den Eingängen (X, Y) angelegt werden, wobei am Ausgang ein Kombinationssignal (f_{K}) bereitgestellt wird, woraus sich eine Überlagerung mit einer Gewichtsfunktion der Steuergröße (K) und eine Integrationswirkung der Signale ergibt, die an den Eingängen (X, Y) angelegt sind,
- eine Formungsschaltung (F), die das Kombinationssignal empfängt, das zweite Zwischentaktsignal (CLK3i) liefert und eine Schwellwertstufe aufweist.

7. Vorrichtung nach einem der vorangegangenen Ansprüche, **dadurch gekennzeichnet, daß** der Emitter (2) ein Generator für pseudozufällige Daten ist.

8. Vorrichtung nach einem der vorangegangenen Ansprüche, **dadurch gekennzeichnet, daß** der Empfänger (3) eine logische Schaltung ist, welche die Integrität der binären Signale am Ausgang des Demultiplexers (5) bei reellen Benutzungsbedingungen verifizieren kann.

## Claims

1. Device for testing the dynamic characteristics of an electronic component or electronic circuit using serial transmissions, the said component or circuit comprising a multiplexing device (4) and a demultiplexing device (5) for implementing a serial link in the component or circuit, the said test device comprising a transmitter (2) supplying to the multiplexing device (4) binary signals to be multiplexed, a receiver (3) receiving the demultiplexed binary signals at the output of the demultiplexing device (5), a connection (6) providing, by means of a control switch (B), the direct connection between the output of the multiplexing device (4) and the input of the demultiplexing device (5), and **characterised in that** it comprises a device (9) delivering a first clock signal (CLK2) and a second clock signal (CLK3), the first clock signal (CLK2) being applied as an input to the transmitter (2), the second clock signal (CLK3) being applied as an input to the receiver, the first clock signal (CLK2) and the second clock signal (CLK3) having different frequencies.

2. Test device according to Claim 1, **characterised in that** the first clock signal (CLK2) and the second clock signal (CLK3) are delivered by a device (1) comprising a single programmable-frequency oscillator (10) and by a variable-delay circuit (13), the programmable-frequency oscillator (10) delivering the first clock signal (CLK2), the variable-delay circuit (13) delivering the second clock signal (CLK3) whilst delaying the first clock signal (CLK2).

3. Test device according to Claim 2, **characterised in that** the variable-delay circuit (13) is adjustable in a linear fashion according to a numerical instruction value (CN2), the delay between the first clock signal (CLK2) and the second clock signal (CLK3) being able to attain at least the value of a period of the first clock signal (CLK2).

4. Test device according to any one of the preceding claims, **characterised in that** the first clock signal (CLK2) and the second clock signal (CLK3) have frequencies of around 100 MHz.

5. Test device according to any one of the preceding claims, **characterised in that** it supplies a frequency difference between the first clock signal (CLK2) and the second clock signal (CLK3) of around 2 per 10,000.

6. Test device according to any one of the preceding claims, **characterised in that** the variable-delay circuit (13) comprises a succession of elementary variable-delay circuits (12) disposed in series, each elementary variable-delay circuit (12) supplying as an output a second intermediate clock signal (CLK3i) exhibiting a delay (X) with respect to a first intermediate clock signal (CLK2i), the delay (X) being adjustable according to a delay instruction (CN), the elementary variable-delay circuit (12) comprising
- a primary circuit (Dl) comprising a set of buffers (T1, T2, T3) in series, delaying for each one the signal at its output by a delay (T) , at the output of which at least first and second delayed signals (r1, r2) are obtained, the first intermediate clock signal (CLK2i) and the delayed signals (r1, r2) being applied to the inputs of a first and second multiplexer (MUX0, MUX1) which supply first and second intermediate signals (m0, m1),
- a combination circuit (C) with two inputs (X, Y), comprising a control input (CD) receiving a control quantity (K) representing the delay instruction (CN), a common line (L), a first and second charge and discharge module (U0, U1) for the common line (L) controlled respectively by the first and second intermediate signals (m0, m1), the potential of the common line (L) constituting the measurement of the combination signal (f_{K}), the intermediate signals (m0, m1) being applied to the inputs (X, Y), supplying as an output a combination signal (f_{K}) resulting from a superimposition with a weighting which is a function of the control quantity (K) and an effect of integration of the signals applied to its inputs (X, Y),
- a shaping circuit (F) receiving the combination signal, supplying the second intermediate clock signal (CLK3i), and exhibiting a threshold effect.

7. Test device according to any one of the preceding claims, **characterised in that** the transmitter (2) is a pseudo-random data generator.

8. Test device according to any one of the preceding claims, **characterised in that** the receiver (3) is a logic circuit for verifying the integrity of the binary signals output from the demultiplexing device (5) under actual conditions of use.
